# EUROPEAN PATENT SPECIFICATION

(11) **EP 1 965 423 B1**
(45) Date of publication and mention of the grant of the patent: **26.10.2011**
(21) Application number: 08003473.9
(22) Date of filing: 26.02.2008
(51) Int. Cl.: H01L 23/373, H01L 23/498, B23K 35/28

(54) **Method for producing a metal/ceramic bonding substrate and brazing filler metal for use therein**
Methode zur Herstellung eines Metall-/Keramiksubstrat und Lötfüllmetall dafür
Procédé de fabrication d'un substrat de liaison de métal/céramique et métal d'apport pour brasage correspondant

(30) Priority: 28.02.2007 JP 2007048793
(43) Date of publication of application: 03.09.2008
(73) Proprietor: DOWA METALTECH CO., LTD., Tokyo 101-8617 (JP)
(72) Inventor: Sawabe, Akio, Shiojiri-shi Nagano 399-0745 (JP); Katou, Yasuaki, Shiojiri-shi Nagano 399-0711 (JP)
(74) Representative: Manitz, Finsterwald & Partner GbR

(56) References cited:
- EP-A1- 0 868 961
- EP-A1- 1 295 671
- EP-A2- 0 839 598
- JP-A- 2006 066 752
- US-A- 5 354 415
- US-A1- 2004 154 830
- US-A1- 2006 219 756
- US-B1- 6 354 484
- JUN SHEN ET AL: "Nano ZrO2 particulate-reinforced lead-free solder composite" JOURNAL OF MATERIALS SCIENCE & TECHNOLOGY, ZHONGGUO KEXUEYUAN, CN, vol. 22, no. 4, 1 January 2006 (2006-01-01), pages 529-532, XP008121467 ISSN: 1005-0302
- J. SHEN, Y.C. LIU, Y.J. HAN, Y.M. TIAN, H.X. GAO: "Strengthening Effects of ZrO2 Nanoparticles on the Microstructure and Microhardness of Sn-3.5Ag Lead-Free Solder" MATERIAL SCIENCE AND ENGINEERING, vol. 441, 2006, pages 135-141, XP002578039
- O. SMORYGO, J.S. KIM, M.D. KIM, T.G. EOM: "Evolution of the interlayer microstructure and the fracture modes of the zirconia/Cu-Ag-Ti filler/Ti active brazing joints" MATERIALS LETTERS, vol. 61, 8 June 2006 (2006-06-08), pages 613-616, XP002578040
- MICHAEL L. SANTELLA, JOSEPH A. HORTON, JONG JIN PAK: "Microstructure of Alumina Brazed with a Silver-Copper-Titanium Alloy" JOOURNAL OF THE AMERICAN CERAMIC SOCIETY, vol. 73, no. 6, June 1990 (1990-06), pages 1785-1787, XP002578037
- J. SHEN, Y.C. LIU, Y.J. HAN, Y.M. TIAN, H.X. GAO: "Strengthening Effects of ZrO2 Nanoparticles on the Microstructure and Microhardness of Sn-3.5Ag Lead-Free Solder" JOURNAL OF ELECTRONIC MATERIALS, vol. 35, no. 8, 2006, pages 1672-1679, XP002578038
- T.H. CHUANG, M.S. YEH, Y.H. CHAI: "Brazing of Zirconia with AgCuTi and SnAgTi Active Filler Metals" METALLURGICAL AND MATERIALS TRANSACTIONS A, vol. 31A, June 2000 (2000-06), pages 1591-1597, XP002576057 Retrieved from the Internet: URL:http://ntur.lib.ntu.edu.tw/bitstream/2 46246/95907/1/48.pdf>
- O. FOCUS: "Laboratory Report" MATERIALS EVALUTAION AND ENGENEERING, INC. 22 April 1998 (1998-04-22), pages 1-12, XP002576058 Retrieved from the Internet: URL:http://mee-inc.com/report1.pdf>

## Description

### BACKGROUND OF THE INVENTION

### Field of the Invention

The present invention generally relates to method for producing a metal/ceramic bonding substrate and a brazing filler metal for use therein. More specifically, the invention relates to a method for producing a metal/ceramic bonding substrate wherein a metal plate is bonded to a ceramic substrate via a brazing filler metal, and a brazing filler metal for use therein.

### Description of the Prior Art

Conventionally, a power module is used for controlling heavy-current for electric vehicles, electric railcars, machine tools and so forth. The power module uses a metal/ceramic bonding substrate wherein metal plates are bonded to both sides of a ceramic substrate. On one side (the reverse or heat sink face) of such a metal/ceramic bonding substrate, a heat sink plate (a base plate), such as a relatively thick copper plate, is fixed by soldering. On the other side (the upper face) of the metal/ceramic bonding substrate, semiconductor chips are fixed by soldering.

As ceramic substrates for metal/ceramic bonding substrates, there are used substrates of ceramic materials of nitrides which have light weight, high hardness, excellent electrical insulation performance, excellent heat resistance, excellent corrosion resistance and so forth. There is known a method (the active metal method) for arranging a brazing filler metal containing an active metal between a metal plate, such as a copper plate, and a ceramic substrate, such as an aluminum nitride (A1N) substrate to bond the metal plate to the ceramic substrate by heating (see, e.g., Japanese Patent Laid-Open No. 60-177634).

In recent years, Pb-free solders (solders which do not substantially contain lead) are substituted for conventional Pb containing solders (solders which contain lead) from the point of view of environmental pollution control. Metal/ceramic bonding substrates begin to use Pb-free solders for fixing semiconductor chips thereto. However, if a Pb-free solder is used for fixing a metal base plate (a heat sink plate) to the reverse face (the heat sink face) of a metal/ceramic bonding substrate for use in a power module or the like, there is a problem in that stress applied to the metal/ceramic bonding substrate increases during thermal shock, so that cracks are produced in the ceramic substrate (particularly in the case of a copper/ceramic bonding substrate wherein a metal plate of copper or a copper alloy is bonded to a ceramic substrate) . There is also a problem in that cracks are produced in the solder after heat cycles are repeatedly applied to the metal/ceramic bonding substrate. It is considered that the reason for this is that the function of relieving stress due to the plastic deformation of the solder is small since Pb-free solders are harder than conventional solders. For that reason, it is desired to provide a metal/ceramic bonding substrate capable of preventing cracks from being produced in the solder and ceramic substrate even if a Pb-free solder is used for fixing a heat sink plate to the metal/ceramic bonding substrate.

EP 0 868 961 A1 relates to a brazing material for use in joining a metal plate to a ceramic substrate, which contains 90 to 99.5 % silver powder, at most 9.5 % copper powder, 0.5 to 4.0 % active metal powder and at most 0.9 % titanium oxide powder.

Shen et al. disclose in J. Mater. Sci. Technol., vol. 22, no. 4, 2006, page 529 to 532 a lead-free solder composite being prepared by adding 1 wt.% or 2 wt.% of ZrO₂ nanopowder in eutectic Sn-Ag-alloys.

### SUMMARY OF THE INVENTION

It is therefore an obj ect of the present invention to eliminate the aforementioned problems and to provide a metal/ceramic bonding substrate having an excellent heat cycle resistance, and a brazing filler metal for use therein.

In order to accomplish the aforementioned and other objects, the inventors have diligently studied and found that it is possible to produce a metal/ceramic bonding substrate having an excellent heat cycle resistance if a brazing filler metal, which is obtained by adding a powder consisting of 0 to 40 wt% of copper, 0.5 to 4 . 5 wt% of an active metal, 0 to 2 wt% of titanium oxide, 0.1 to 5 wt% of zirconium oxide and the balance being silver to a vehicle to knead them, is used for bonding a metal plate to a ceramic substrate. Thus, the inventors have made the present invention.

According one aspect of the present invention, a method for producing a metal/ceramic bonding substrate comprises the steps of:
- adding a powder consisting of 0 to 40 wt% of copper, 0.5 to 4.5 wt% of an active metal, 0 to 2 wt% of titanium oxide, 0.1 to 5 wt% of zirconium oxide and the balance being silver to a vehicle to knead the mixture of the powder and the vehicle to produce a brazing filler metal;
- applying the brazing filler metal on a ceramic substrate;
- arranging a metal plate on the brazing filler metal; and
- heating the metal plate, the brazing filler metal and the ceramic substrate to bond the metal plate to the ceramic substrate via the brazing filler metal.

Preferably, in this method the content of copper in the powder is in the range of from 1 to 35 wt%, the content of the active metal in the powder is in the range of from 1 to 3 wt%, the content of titanium oxide in the powder is in the range of from 0.2 to 1 wt% and the content of zirconium oxide in the powder is in the range of from 0.2 to 5 wt%. Even more preferably, in this method the content of copper in the powder is in the range of from 5 to 30 wt%, the content of the active metal in the powder is in the range of from 1 to 2 wt%, the content of titanium oxide in the powder is in the range of from 0.2 to 0.9 wt% and the content of zirconium oxide in the powder is in the range of from 0.2 to 1 wt%. It is also preferable that the active metal is at least one metal selected from the group consisting of titanium, zirconium and hafnium or a hydride thereof and/or that the vehicle contains an acrylic binder and a solvent.

According to another aspect of the present invention, a brazing filler metal comprises: a vehicle; and a powder added to the vehicle to be kneaded, the powder consisting of 0 to 40 wt% of copper, 0.5 to 4 . 5 wt% of an active metal, 0 to 2 wt% of titanium oxide, 0.1 to 5 wt% of zirconium oxide and the balance being silver. Preferably, in this brazing filler metal, the content of copper in the powder is in the range of from 1 to 35 wt%, the content of the active metal in the powder being in the range of from 1 to 3 wt%, the content of titanium oxide in the powder being in the range of from 0.2 to 1 wt%, and the content of zirconium oxide in the powder being in the range of from 0.2 to 5 wt%. More preferably, in the brazing filler metal, the content of copper in the powder is in the range of from 5 to 30 wt%, the content of the active metal in the powder being in the range of from 1 to 2 wt%, the content of titanium oxide in the powder being in the range of from 0.2 to 0 . 9 wt%, and the content of zirconium oxide in the powder being in the range of from 0.2 to 1 wt%.

According to the present invention, it is possible to provide a metal/ceramic bonding substrate having an excellent heat cycle resistance, and a brazing filler metal for use therein.

### BRIEF DESCRIPTION OF THE DRAWINGS

FIG. 1 is a graph showing initial bending strengths in three-point bending, and bending strengths in three-point bending after three passages through furnace, with respect to the amount of zirconium oxide in Examples 2 through 5 and Comparative Example;
FIG. 2 is a graph showing furnace passing resistances with respect to the amount of zirconium oxide in Examples 2 through 5 and Comparative Example;
FIG. 3 is a graph showing partial discharge starting voltages of the same samples as those of metal/ceramic bonding substrates obtained in Example 3 and Comparative Example; and
FIG. 4 is a graph showing insulation resistances when the same samples as those of metal/ceramic bonding substrates obtained in Example 3 and Comparative Example are heated at 125 °C .

### DESCRIPTION OF THE PREFERRED EMBODIMENTS

According to the present invention, a metal/ceramic bonding substrate is produced by a method comprising the steps of: applying a paste-like brazing filler metal, which is produced by adding a powder consisting of 0 to 40 wt% of copper, 0.5 to 4.5 wt% of an active metal, 0 to 2 wt% of titanium oxide, 0.1 to 5 wt% of zirconium oxide and the balance being silver to a vehicle to knead them, on a ceramic substrate; arranging a metal plate on the brazing filler metal; and heating them to bond the metal plate to the ceramic substrate via the brazing filler metal.

If the amount of silver in the powder which is added to the vehicle is less than 60 wt%, the melting point of the brazing filler metal is far higher than the eutectic point of silver and copper, so that there is the possibility that energy costs and thermal stress may increase and/or bonding failure, such as voids, in the brazing filler metal may increase. Therefore, the amount of silver in the powder is preferably in the range of from 60 to 99 wt%, more preferably in the range of from 70 to 95 wt%, and most preferably in the range of from 80 to 95 wt%.

If the amount of copper in the powder exceeds 40 wt%, the melting point of the brazing filler metal is far higher than the eutectic point of silver and copper as described above, so that there is the possibility that energy costs and thermal stress may increase and/or bonding failure, such as voids, in the brazing filler metal may increase. Therefore, the amount of copper in the powder is preferably in the range of from 0 to 40 wt%, more preferably in the range of from 1 to 35 wt%, and most preferably in the range of from 5 to 35 wt%. Furthermore, if copper is not contained in the powder or if the amount of copper contained in the powder is too small, the melting point of the brazing filler metal is far higher than the eutectic point of silver and copper. However, the melting point of the brazing filler metal can be a temperature not higher than 960 °C which is the melting point of silver. In addition, if the metal plate bonded to the ceramic substrate contains elements, such as copper and aluminum, there are many cases where the brazing filler metal reacts with the elements to melt at a lower temperature than the melting point thereof when the metal plate is bonded to the ceramic substrate. In such cases, there are not the above described problems.

The active metal may be at least one metal selected from the group consisting of titanium, zirconium and hafnium or a hydride thereof. If the amount of the active metal in the powder is less than 0.5 wt%, the amount of the nitride layer produced between the metal plate and the ceramic substrate decreases, so that the bond strength is very weak. On the other hand, if the amount of the active metal in the powder exceeds 4.5 wt%, cracks tend to be produced in the solder and ceramic substrate after bonding. Therefore, the amount of the active metal in the powder is preferably in the range of from 0.5 to 4.5 wt%, more preferably in the range of from 1 to 3 wt%, and most preferably in the range of from 1 to 2 wt%.

The form of titanium oxide may be any one of TiO, Ti₂O₃ and TiO₂. If the amount of titanium oxide in the powder exceeds 2 wt%, it is difficult to bond the metal plate to the ceramic substrate. Therefore, the amount of titanium oxide in the powder is preferably in the range of from 0 to 2 wt%. In addition, titanium oxide may be crystalline or amorphous. Furthermore, if the brazing filler metal contains both of titanium oxide and zirconium oxide, it is possible to considerably relieve thermal stress produced in the metal and ceramics of the metal/ceramic bonding substrate. Therefore, the amount of titanium oxide in the powder is more preferably in the range of from 0.2 to 1 wt% of titanium oxide, and most preferably in the range of from 0.2 to 0.9 wt% of titanium oxide.

The form of zirconium oxide may be any one of ZrO and Zr0₂. If the amount of zirconium oxide in the powder is less than 0.1 wt%, it is not possible to produce a metal/ceramic bonding substrate having excellent characteristics with respect to heat cycle resistance, bending strength, flexure quantity, furnace passing resistance, insulation resistance, partial discharge and so forth. On the other hand, if the amount of zirconium oxide in the powder exceeds 5 wt%, it is difficult to bond the metal plate to the ceramic substrate. Therefore, the amount of zirconium oxide in the powder is preferably in the range of from 0.1 to 5 wt%, more preferably in the range of from 0.2 to 5 wt%, and most preferably in the range of 0.2 to 1 wt%. The reason why the above described characteristics are improved by using a brazing filler metal containing the above described range of zirconium oxide is not clear. However, it is considered that, if the brazing filler metal contains zirconium oxide having a high fracture toughness value, it is possible to relieve stress due to the expansion and reduction of the metal plate, such as a copper plate, when heat cycles are repeatedly applied to the metal/ceramic bonding substrate, so that it is possible to reduce the influence on the metal/ceramic bonding substrate. In addition, zirconium oxide may be crystalline or amorphous. The crystal system thereof may be any one of cubic, tetragonal and rhombic systems.

Furthermore, after the distribution of composition on the cross section of the brazing filler metal was observed by an electron probe microanalyzer (EPMA), zirconium oxide in the brazing filler metal was combined with the active metal to be uniformly dispersed. When the brazing filler metal does not contain zirconium oxide, the active metal was concentrated as a layer near the surface of the ceramic substrate. The layer of the active metal is a friable layer. It is considered that, if zirconium oxide is added to the brazing filler metal or if both of zirconium oxide and titanium oxide are added to the brazing filler metal, zirconium oxide in the brazing filler metal is combined with the active metal to remove or thin the friable layer of the active layer, so that it is possible to improve characteristics, such as heat cycle resistance, bending strength, flexure quantity and furnace passing resistance. Furthermore, it is also possible to improve insulation resistance and partial discharge if zirconium oxide is added to the brazing filler metal or if both of zirconium oxide and titanium oxide are added to the brazing filler metal, although the reason for this is not clear.

Examples of a metal/ceramic bonding substrate and a brazing filler metal for use therein according to the present invention will be described below in detail.

### Example 1

First, 12.2 parts by weight of a vehicle (a vehicle containing an acrylic binder and a solvent) was added to 100 parts by weight of a powder consisting of 92.0 wt% of silver powder, 6.0 wt% of copper powder, 1.5 wt% of titanium powder and 0.5 wt% of ZrO₂ powder as solid parts to be kneaded to produce a paste-like brazing filler metal. Then, the brazing filler metal thus obtained was applied on the whole area of both faces of an A1N substrate (a ceramic substrate) having a size of 46 mm x 43 mm x 0. 6 mm. Then, a copper plate (a metal plate) having a thickness of 0.3 mm was arranged on each face of the ceramic substrate via the brazing filler metal. Then, they were inputted into a bonding furnace to be heated at 835 °C to bond the metal plates to the ceramic substrate. Thereafter, an etching resist having a predetermined circuit pattern shape was formed on one of the metal plates to remove unnecessary portions of the metal and brazing filler metal with chemicals, and then, the etching resist was removed to obtain a metal/ceramic bonding substrate having a predetermined circuit pattern.

With respect to five samples of the metal/ceramic bonding substrates obtained in this example, a furnace passing treatment (a treatment wherein each of the samples was cooled to a room temperature after it was heated at 400 °C for two minutes in a reducing atmosphere (hydrogen/nitrogen = 20/80)) was repeated, and the reliability of the samples was evaluated on the basis of a furnace passing resistance (the number of furnace passing times). That is, the occurrence of cracks in the ceramic substrate after the furnace passing treatment was visually inspected by means of a magnifying glass, and it was assumed that the number of furnace passing treatments immediately before the number of furnace passing treatments causing a crack was a furnace passing resistance (the number of furnace passing times). By this furnace passing resistance, the reliability of the metal/ceramic bonding substrate was evaluated. As a result, each of the minimum, maximum and mean values of the furnace passing resistance (the number of furnace passing times) of the five samples of the metal/ceramic bonding substrates obtained in this example was 15.

In addition, with respect to the metal/ceramic bonding substrate obtained in this example, an initial bending strength in three-point bending and a bending strength in three-point bending after three passages through furnace (a treatment for cooling the substrate to a room temperature after heating it at 370 °C for two minutes in a reducing atmosphere (hydrogen/nitrogen = 20/80) was repeated three times) were measured on measurement conditions of a load speed (crosshead speed) of 0.5 mm/min and a span length of 30 mm. As the bending strength in three-point bending after three passages through furnace is higher, the heat cycle resistance of the metal/ceramic bonding substrate is higher. As a result, the initial bending strength was 701 MPa, and the bending strength after three passages through furnace was 371 MPa.

The flexure quantity of the metal plate was measured when the metal/ceramic bonding substrate was broken during the measurement of the bending strength in three-point bending. As a result, the initial flexure quantity was 0.40 mm, and the flexure quantity after three passages through furnace was 0.22 mm.

### Comparative Example

Five metal/ceramic bonding substrates were obtained by the same method as that in Example 1, except that titanium oxide was substituted for zirconiumoxide, i.e., except that a powder consisting of 92.0 wt% of silver powder, 6.0 wt% of copper powder, 1.5 wt% of titanium powder and 0.5 wt% of TiO₂ powder was used. With respect to five samples of the metal/ceramic bonding substrates obtained in this comparative example, the furnace passing resistance (the number of furnace passing times), the initial bending strength in three-point bending, the bending strength in three-point bending after three passages through furnace, the initial flexure quantity, and the flexure quantity after three passages through furnace were measured by the same methods as those in Example 1. As a result, the minimum value of the furnace passing resistance (the number of furnace passing times) was 7, the maximum value thereof was 10, and the mean value thereof was 7.6. In addition, the initial bending strength in three-point bending was 707 MPa, and the bending strength in three-point bending after three passages through furnace was 307 MPa. Moreover, the initial flexure quantity was 0.40 mm, and the flexure quantity after three passages through furnace was 0.19 mm.

### Example 2

Five metal/ceramic bonding substrates were obtained by the same method as that in Example 1, except that a powder consisting of 91.8 wt% of silver powder, 6.0 wt% of copper powder, 1.5 wt% of titanium powder, 0.5 wt% of TiO₂ powder and 0.2 wt% of ZrO₂ powder was used. With respect to five samples of the metal/ceramic bonding substrates obtained in this example, the furnace passing resistance (the number of furnace passing times), the initial bending strength in three-point bending, the bending strength in three-point bending after three passages through furnace, the initial flexure quantity, and the flexure quantity after three passages through furnace were measured by the same methods as those in Example 1. As a result, the minimum value of the furnace passing resistance (the number of furnace passing times) was 15, the maximum value thereof was 35, and the mean value thereof was 25. In addition, the initial bending strength in three-point bending was 712 MPa, and the bending strength in three-point bending after three passages through furnace was 440 MPa. Moreover, the initial flexure quantity was 0.42 mm, and the flexure quantity after three passages through furnace was 0.25 mm.

### Example 3

Five metal/ceramic bonding substrates were obtained by the same method as that in Example 1, except that a powder consisting of 91.5 wt% of silver powder, 6.0 wt% of copper powder, 1 . 5 wt% of titanium powder, 0.5 wt% of TiO₂ powder and 0 . 5 wt% of ZrO₂ powder was used. With respect to five samples of the metal/ceramic bonding substrates obtained in this example, the furnace passing resistance (the number of furnace passing times), the initial bending strength in three-point bending, the bending strength in three-point bending after three passages through furnace, the initial flexure quantity, and the flexure quantity after three passages through furnace were measured by the same methods as those in Example 1 . As a result, the minimum value of the furnace passing resistance (the number of furnace passing times) was 25, the maximum value thereof was 40, and the mean value thereof was 34. In addition, the initial bending strength in three-point bending was 735 MPa, and the bending strength in three-point bending after three passages through furnace was 585 MPa. Moreover, the initial flexure quantity was 0.43 mm, and the flexure quantity after three passages through furnace was 0.32 mm.

### Example 4

Five metal/ceramic bonding substrates were obtained by the same method as that in Example 1, except that a powder consisting of 91.0 wt% of silver powder, 6.0 wt% of copper powder, 1.5 wt% of titanium powder, 0.5 wt% of TiO₂ powder and 1.0 wt% of ZrO₂ powder was used. With respect to five samples of the metal/ceramic bonding substrates obtained in this example, the furnace passing resistance (the number of furnace passing times), the initial bending strength in three-point bending, the bending strength in three-point bending after three passages through furnace, the initial flexure quantity, and the flexure quantity after three passages through furnace were measured by the same methods as those in Example 1 . As a result, the minimum value of the furnace passing resistance (thenumberof furnace passing times) was 25, the maximum value thereof was 35, and the mean value thereof was 31. In addition, the initial bending strength in three-point bending was 670 MPa, and the bending strength in three-point bending after three passages through furnace was 584 MPa. Moreover, the initial flexure quantity was 0.40 mm, and the flexure quantity after three passages through furnace was 0.34 mm.

### Example 5

Five metal/ceramic bonding substrates were obtained by the same method as that in Example 1, except that a powder consisting of 87.6 wt% of silver powder, 5.7 wt% of copper powder, 1.4 wt% of titanium powder, 0.5 wt% of TiO₂ powder and 4.8 wt% of ZrO₂ powder was used. With respect to five samples of the metal/ceramic bonding substrates obtained in this example, the furnace passing resistance (the number of furnace passing times), the initial bending strength in three-point bending, the bending strength in three-point bending after three passages through furnace, the initial flexure quantity, and the flexure quantity after three passages through furnace were measured by the same methods as those in Example 1 . As a result, the minimum value of the furnace passing resistance (the number of furnace passing times) was 20, the maximum value thereof was 35, and the mean value thereof was 27. In addition, the initial bending strength in three-point bending was 660 MPa, and the bending strength in three-point bending after three passages through furnace was 590 MPa. Moreover, the initial flexure quantity was 0.42 mm, and the flexure quantity after three passages through furnace was 0.32 mm.

### Example 6

Five metal/ceramic bonding substrates were obtained by the same method as that in Example 1, except that a powder consisting of 81.4 wt% of silver powder, 16. 1 wt% of copper powder, 1.5 wt% of titanium powder, 0.5 wt% of TiO₂ powder and 0.5 wt% of ZrO₂ powder was used. With respect to five samples of the metal/ceramic bonding substrates obtained in this example, the furnace passing resistance (the number of furnace passing times), the initial bending strength in three-point bending, the bending strength in three-point bending after three passages through furnace, the initial flexure quantity, and the flexure quantity after three passages through furnace were measured by the same methods as those in Example 1 . As a result, the minimum value of the furnace passing resistance (the number of furnace passing times) was 20, the maximum value thereof was 30, and the mean value thereof was 25. In addition, the initial bending strength in three-point bending was 664 MPa, and the bending strength in three-point bending after three passages through furnace was 426 MPa. Moreover, the initial flexure quantity was 0.39 mm, and the flexure quantity after three passages through furnace was 0.25 mm.

### Example 7

Five metal/ceramic bonding substrates were obtained by the same method as that in Example 1, except that a powder consisting of 70.0 wt% of silver powder, 27.0 wt% of copper powder, 2. 0 wt% of titanium powder, 0.5 wt% of TiO₂ powder and 0.5 wt% of ZrO₂ powder was used. With respect to five samples of the metal/ceramic bonding substrates obtained in this example, the furnace passing resistance (the number of furnace passing times), the initial bending strength in three-point bending, the bending strength in three-point bending after three passages through furnace, the initial flexure quantity, and the flexure quantity after three passages through furnace were measured by the same methods as those in Example 1. As a result, the minimum value of the furnace passing resistance (the number of furnace passing times) was 15, the maximum value thereof was 25, and the mean value thereof was 22. In addition, the initial bending strength in three-point bending was 652 MPa, and the bending strength in three-point bending after three passages through furnace was 403 MPa. Moreover, the initial flexure quantity was 0.38 mm, and the flexure quantity after three passages through furnace was 0.22 mm.

### Example 8

Five metal/ceramic bonding substrates were obtained by the same method as that in Example 1, except that a powder consisting of 91.1 wt% of silver powder, 6.0 wt% of copper powder, 1 . 5 wt% of titanium powder, 0.9 wt% of TiO₂ powder and 0 . 5 wt% of ZrO₂ powder was used. With respect to five samples of the metal/ceramic bonding substrates obtained in this example, the furnace passing resistance (the number of furnace passing times), the initial bending strength in three-point bending, the bending strength in three-point bending after three passages through furnace, the initial flexure quantity, and the flexure quantity after three passages through furnace were measured by the same methods as those in Example 1. As a result, the minimum value of the furnace passing resistance (the number of furnace passing times) was 20, the maximum value thereof was 30, and the mean value thereof was 26. In addition, the initial bending strength in three-point bending was 670 MPa, and the bending strength in three-point bending after three passages through furnace was 430 MPa. Moreover, the initial flexure quantity was 0.39 mm, and the flexure quantity after three passages through furnace was 0.28 mm.

The compositions of the powders added to the brazing filler metals in Examples 1 through 8 and Comparative Example, and the test results of the metal/ceramic bonding substrates produced therein are shown in Tables 1 and 2, respectively.

**Table 1**

| | Powder (wt. %) | | | | |
|---|---|---|---|---|---|
| | ZrO₂ | TiO₂ | Ag | Cu | Ti |
| Comp. | 0 | 0.5 | 92.0 | 6.0 | 1.5 |
| Ex.1 | 0.5 | 0 | 92.0 | 6.0 | 1.5 |
| Ex.2 | 0.2 | 0.5 | 91.8 | 6.0 | 1.5 |
| Ex.3 | 0.5 | 0.5 | 91.5 | 6.0 | 1.5 |
| Ex.4 | 1.0 | 0.5 | 91.0 | 6.0 | 1.5 |
| Ex.5 | 4.8 | 0.5 | 87.6 | 5.7 | 1.4 |
| Ex.6 | 0.5 | 0.5 | 81.4 | 16.1 | 1.5 |
| Ex.7 | 0.5 | 0.5 | 70.0 | 27.0 | 2.0 |
| Ex.8 | 0.5 | 0.9 | 91.1 | 6.0 | 1.5 |

**Table 2**

| | Strength (Mean Value) | | | | Furnace Passing Resistance (Furnace Passing Times) | | |
|---|---|---|---|---|---|---|---|
| | Initial Bending Strength (MPa) | Bending Strength After Three Passages Through Furnace (MPa) | Initial Flexure Quantity (mm) | Flexure Quantity After Three Passages Through Furnace (mm) | Minimum Value (Times) | Maximum Value (Times) | Mean Value (Times) |
| Comp. | 707 | 307 | 0.40 | 0.19 | 7 | 10 | 7.6 |
| Ex. 1 | 701 | 371 | 0.40 | 0.22 | 15 | 15 | 15 |
| Ex.2 | 712 | 440 | 0.42 | 0.25 | 15 | 35 | 25 |
| Ex.3 | 735 | 585 | 0.43 | 0.32 | 25 | 40 | 34 |
| Ex.4 | 670 | 584 | 0.40 | 0.34 | 25 | 35 | 31 |
| Ex.5 | 660 | 590 | 0.42 | 0.32 | 20 | 35 | 27 |
| Ex.6 | 664 | 426 | 0.39 | 0.25 | 20 | 30 | 25 |
| Ex.7 | 652 | 403 | 0.38 | 0.22 | 15 | 25 | 22 |
| Ex.8 | 670 | 430 | 0.39 | 0.28 | 20 | 30 | 26 |

As can be seen from Table 2, the furnace passing resistances of the metal/ceramic bonding substrates in Examples 1 thorough 8 are twice to five times or more as many as that of the metal/ceramic bonding substrate in Comparative Example. In addition, the bending strengths and flexure quantities after three passages through furnace in Examples 1 thorough 8 are far higher than those of the metal/ceramic bonding substrate in Comparative Example. Moreover, even if only zirconium oxide is added as an oxide without adding titanium oxide as shown in Example 1, the furnace passing resistance, the bending strength after three passages through furnace, and the flexure quantity after three passages through furnace can be improved as compared with those in Comparative Example wherein titanium oxide is added without adding zirconium oxide. If both of titanium oxide and zirconium oxide are added as shown in Examples 2 through 8, it is possible to further improve the furnace passing resistance, the bending strength after three passages through furnace, and the flexure quantity after three passages through furnace.

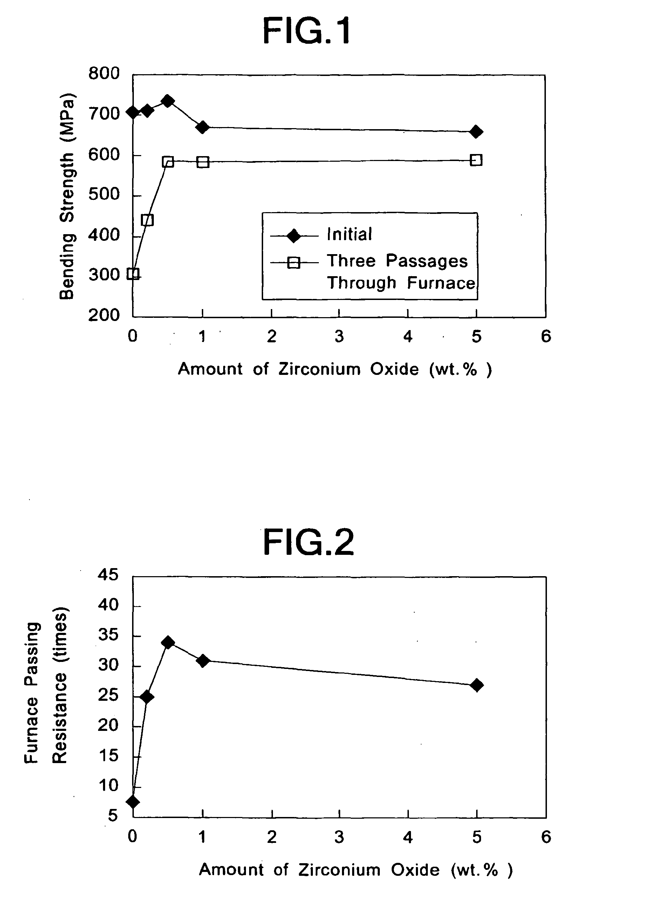

FIG. 1 shows the initial bending strengths in three-point bending, and the bending strengths in three-point bending after three passages through furnace, with respect to the amount of zirconium oxide in Examples 2 through 5 and Comparative Example. FIG. 2 shows the furnace passing resistances with respect to the amount of zirconium oxide in Examples 2 through 5 and Comparative Example. As shown in these figures, the furnace passing resistances, the bending strength in three-point bending after three passages through furnace, and the flexure quantity after three passages through furnace are improved by adding a small amount of zirconium oxide. There values are the maximum values when the amount of zirconium oxide is 0 . 5 wt%, and are saturated or slightly decreased when the amount of zirconium oxide exceeds 0.5 wt%. In particular, when the amount of zirconium oxide is not less than 0.5 wt%, the furnace passing resistances are three to five times as many as those of the metal/ceramic bonding substrate in Comparative Example, and the bending strengths after three passages through furnace are about twice as much as that of the metal/ceramic bonding substrate in Comparative Example.

In Examples 6 and 7, the amount of silver is decreased, and the amount of copper is increased. In these examples, the furnace passing resistances are three times or more as many as those in Comparative Example, and the bending strengths after three passages through furnace are higher than that in Comparative Example by 100 MPa or more.

### Example 9

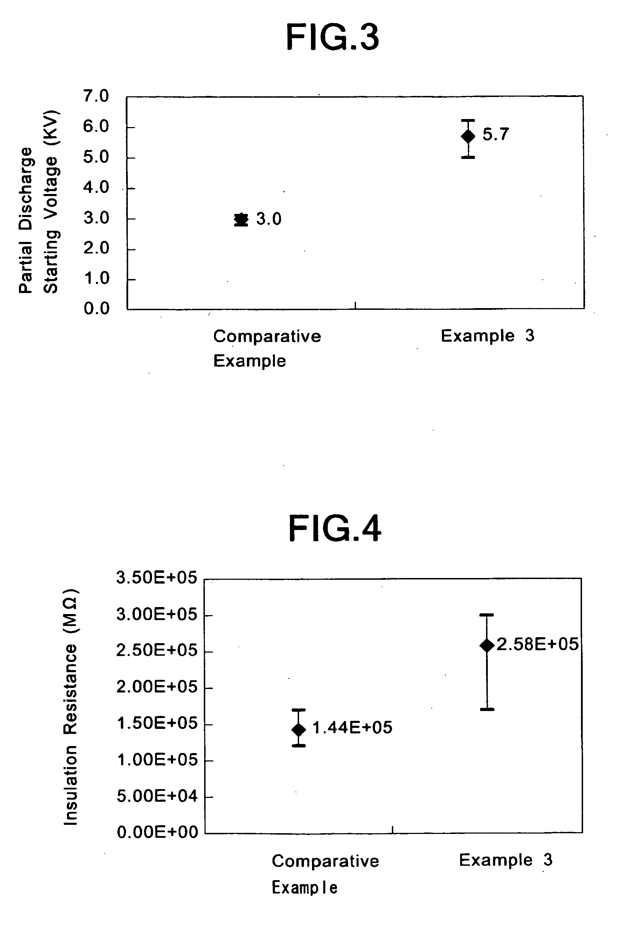

With respect to each of the same samples as those of the metal/ceramic bonding substrates obtained in Example 3 and Comparative Example, a partial discharge measuring test was carried out. In this partial discharge measuring test, each of the samples was arranged in an insulating oil to apply an alternating voltage thereto, and it was assumed that the applied voltage was a partial discharge starting voltage when it exceeded a discharge of 10 Pc. The results thereof are shown in FIG. 3. As shown in FIG. 3, the partial discharge starting voltage of the same sample as that of the metal/ceramic bonding substrate obtained in Example 3 is about twice as much as the partial discharge starting voltage of the same sample as that of the metal/ceramic bonding substrate obtained in Comparative Example.

### Example 10

Each of the same samples as those of the metal/ceramic bonding substrates obtained in Example 3 and Comparative Example was heated to 125 °C to carry out an insulation resistance measuring test. The results thereof are shown in FIG. 4. As shown in FIG. 4, the insulation resistance of the same sample as that of the metal/ceramic bonding substrate obtained in Example 3 is about ten times as much as the insulation resistance of the same sample as that of the metal/ceramic bonding substrate obtained in Comparative Example.

## Claims

1. A method for producing a metal/ceramic bonding substrate comprising the steps of:
adding a powder consisting of 0 to 40 wt% of copper, 0.5 to 4.5 wt% of an active metal, 0 to 2 wt% of titanium oxide, 0.1 to 5 wt% of zirconium oxide and the balance being silver to a vehicle to knead the mixture of the powder and the vehicle to produce a brazing filler metal;
applying the brazing filler metal on a ceramic substrate;
arranging a metal plate on the brazing filler metal; and
heating the metal plate, the brazing filler metal and the ceramic substrate to bond the metal plate to the ceramic substrate via the brazing filler metal.

2. A method for producing a metal/ceramic bonding substrate as set forth in claim 1, wherein the content of copper in said powder is in the range of from 1 to 35 wt%, the content of the active metal in said powder being in the range of from 1 to 3 wt%, the content of titanium oxide in said powder being in the range of from 0.2 to 1 wt%, and the content of zirconium oxide in said powder being in the range of from 0.2 to 5 wt%.

3. A method for producing a metal/ceramic bonding substrate as set forth in claim 1, wherein the content of copper in said powder is in the range of from 5 to 30 wt%, the content of the active metal in said powder being in the range of from 1 to 2 wt%, the content of titanium oxide in said powder being in the range of from 0.2 to 0.9 wt%, and the content of zirconium oxide in said powder being in the range of from 0.2 to 1 wt%.

4. A method for producing a metal/ceramic bonding substrate as set forth in claim 1, wherein said active metal is at least one metal selected from the group consisting of titanium, zirconium and hafnium or a hydride thereof.

5. A method for producing a metal/ceramic bonding substrate as set forth in claim 1, wherein said vehicle contains an acrylic binder and a solvent.

6. A brazing filler metal comprising:
a vehicle; and
a powder added to said vehicle to be kneaded, said powder consisting of 0 to 40 wt% of copper, 0.5 to 4.5 wt% of an active metal, 0 to 2 wt% of titanium oxide, 0.1 to 5 wt% of zirconium oxide and the balance being silver.

7. A brazing filler metal as set forth in claim 6, wherein the content of copper in said powder is in the range of from 1 to 35 wt%, the content of the active metal in said powder being in the range of from 1 to 3 wt%, the content of titanium oxide in said powder being in the range of from 0.2 to 1 wt%, and the content of zirconium oxide in said powder being in the range of from 0.2 to 5 wt%.

8. A brazing filler metal as set forth in claim 6, wherein the content of copper in said powder is in the range of from 5 to 30 wt%, the content of the active metal in said powder being in the range of from 1 to 2 wt%, the content of titanium oxide in said powder being in the range of from 0.2 to 0.9 wt%, and the content of zirconium oxide in said powder being in the range of from 0.2 to 1 wt%.

9. A brazing filler metal as set forth in claim 6, wherein said active metal is at least one metal selected from the group consisting of titanium, zirconium and hafnium or a hydride thereof.

10. A brazing filler metal as set forth in claim 6, wherein said vehicle contains an acrylic binder and a solvent.

## Patentansprüche

1. Verfahren zum Herstellen eines verbundenen Metall-/Keramik-Substrates umfassend die Schritte:
Zugabe eines Pulvers, welches aus 0 bis 40 Gew.-% Kupfer, 0,5 bis 4,5 Gew.-% eines aktiven Metalls, 0 bis 2 Gew.-% Titanoxid, 0,1 bis 5 Gew.-% Zirkoniumoxid und Rest Silber besteht, zu einem Träger, um die Mischung des Pulvers und des Trägers zu kneten, um ein Hartlötfüllmetall herzustellen,
Aufbringen des Hartlötfüllmetalls auf ein Keramiksubstrat,
Anordnen einer Metallplatte auf dem Hartlötfüllmetall und
Erhitzen der Metallplatte, des Hartlötfüllmetalls und des Keramiksubstrats, um die Metallplatte über das Hartlötfüllmetall an das Keramiksubstrat zu binden.

2. Verfahren zum Herstellen eines verbundenen Metall-/Keramik-Substrates nach Anspruch 1, wobei die Menge des Kupfers in dem Pulver in einem Bereich zwischen 1 und 35 Gew.-% liegt, die Menge des aktiven Materials des Pulvers in einem Bereich zwischen 1 und 3 Gew.-% liegt, die Menge des Titanoxids in dem Pulver in einem Bereich zwischen 0,2 und 1 Gew.-% liegt und die Menge des Zirkoniumoxids in dem Pulver in einem Bereich zwischen 0,2 und 5 Gew.-% liegt.

3. Verfahren zum Herstellen eines verbundenen Metall-/Keramik-Substrates nach Anspruch 1, wobei die Menge des Kupfers in dem Pulver in einem Bereich zwischen 5 und 30 Gew.-%, die Menge des aktiven Metalls in dem Pulver in einem Bereich zwischen 1 und 2 Gew.-%, die Menge des Titanoxids in dem Pulver in einem Bereich zwischen 0,2 und 0,9 Gew.-% und die Menge des Zirkoniumoxids in dem Pulver in einem Bereich zwischen 0,2 und 1 Gew.-% liegt.

4. Verfahren zum Herstellen eines verbundenen Metall-/Keramik-Substrates nach Anspruch 1, wobei das aktive Metall wenigstens ein Metall ist, welches aus der Gruppe ausgewählt ist, welche aus Titan, Zirkonium und Hafnium oder einem Hydrid hiervon besteht.

5. Verfahren zum Herstellen eines verbundenen Metall-/Keramik-Substrates nach Anspruch 1, wobei der Träger ein Acryl-Bindemittel und ein Lösungsmittel enthält.

6. Hartlötfüllstoffmetall enthaltend:
einen Träger und
ein Pulver, welches dem zu knetenden Träger zugegeben ist, wobei das Pulver aus 0 bis 40 Gew.-% Kupfer, 0,5 bis 4,5 Gew.-% eines aktiven Metalls, 0 bis 2 Gew.-% Titanoxid, 0,1 bis 5 Gew.-% Zirkoniumoxid und Rest Silber besteht.

7. Hartlötfüllstoffmetall nach Anspruch 6, wobei die Menge des Kupfers in dem Pulver in einem Bereich zwischen 1 und 35 Gew.-%, die Menge des aktiven Metalls in dem Pulver in einem Bereich zwischen 1 und 3 Gew.-%, die Menge des Titanoxids in dem Pulver in einem Bereich zwischen 0,2 und 1 Gew.-% sowie die Menge des Zirkoniumoxids in dem Pulver in einem Bereich zwischen 0,2 und 5 Gew.-% liegt.

8. Hartlötfüllstoffmetall nach Anspruch 6, wobei die Menge des Kupfers in dem Pulver in einem Bereich zwischen 5 und 30 Gew.-%, die Menge des aktiven Metalls in dem Pulver in einem Bereich zwischen 1 und 2 Gew.-%, die Menge des Titanoxids in dem Pulver in einem Bereich zwischen 0,2 und 0,9 Gew.-% und die Menge des Zirkoniumoxids in dem Pulver in einem Bereich zwischen 0,2 und 1 Gew.-% liegt.

9. Hartlötfüllstoffmetall nach Anspruch 6, wobei das aktive Metall wenigstens ein Metall ist, welches aus der Gruppe ausgewählt ist, welche aus Titan, Zirkonium und Hafnium oder einem Hydrid hiervon besteht.

10. Hartlötfüllstoffmetall nach Anspruch 6, wobei der Träger ein Acryl-Bindemittel sowie ein Lösungsmittel enthält.

## Revendications

1. Procédé pour produire un substrat de liaison métal/céramique comprenant les étapes consistant à :
ajouter une poudre constituée de 0 à 40 % en poids de cuivre, 0,5 à 4,5 % en poids d'un métal actif, 0 à 2 % en poids d'oxyde de titane, 0,1 à 5 % en poids d'oxyde de zirconium, le reste étant de l'argent à un matériau véhicule pour pétrir le mélange de poudre et de matériau véhicule pour produire un métal de remplissage et de brasage ;
appliquer le métal de remplissage et de brasage sur un substrat en céramique ;
agencer une plaque de métal sur le métal de remplissage et de brasage ; et
chauffer la plaque de métal, le métal de remplissage et de brasage et le substrat en céramique pour lier la plaque de métal au substrat en céramique via le métal de remplissage et de brasage.

2. Procédé pour produire un substrat de liaison métal/céramique selon la revendication 1, dans lequel la teneur en cuivre dans ladite poudre est dans la plage de 1 à 35 % en poids, la teneur de métal actif dans ladite poudre est dans la plage de 1 à 3 % en poids, la teneur en oxyde de titane dans ladite poudre est dans la plage de 0,2 à 1 % en poids, et la teneur en oxyde de zirconium dans ladite poudre est dans la plage de 0,2 à 5 % en poids.

3. Procédé pour produire un substrat de liaison métal/céramique selon la revendication 1, dans lequel la teneur en cuivre dans ladite poudre est dans la plage de 5 à 30 % en poids, la teneur de métal actif dans ladite poudre est dans la plage de 1 à 2 % en poids, la teneur en oxyde de titane dans ladite poudre est dans la plage de 0,2 à 0,9 % en poids, et la teneur d'oxyde de zirconium dans ladite poudre est dans la plage de 0,2 à 1 % en poids.

4. Procédé pour produire un substrat de liaison métal/céramique selon la revendication 1, dans lequel ledit métal actif est au moins un métal choisi parmi le groupe comprenant titane, zirconium et hafnium ou un hydrure de ceux-ci.

5. Procédé pour produire un substrat de liaison métal/céramique selon la revendication 1, dans lequel ledit matériau véhicule contient un liant acrylique et un solvant.

6. Métal de remplissage et de brasage comprenant :
un matériau véhicule ; et
une poudre ajoutée audit matériau véhicule pour être pétrie, ladite poudre étant constitué de 0 à 40 % en poids de cuivre, 0,5 à 4,5 % en poids d'un métal actif, 0 à 2 % en poids d'oxyde de titane, 0,1 à 5 % en poids d'oxyde de zirconium, le reste étant de l'argent.

7. Métal de remplissage et de brasage selon la revendication 6, dans lequel la teneur en cuivre dans ladite poudre est dans la plage de 1 à 35 % en poids, la teneur en métal actif dans ladite poudre est dans la plage de 1 à 3 % en poids, la teneur en oxyde de titane dans ladite poudre est dans la plage de 0,2 à 1 % en poids, et la teneur en oxyde de zirconium dans ladite poudre est dans la plage de 0,2 à 5 % en poids.

8. Métal de remplissage et de brasage selon la revendication 6, dans lequel la teneur en cuivre dans ladite poudre est dans la plage de 5 à 30 % en poids, la teneur en métal actif dans ladite poudre est dans la plage de 1 à 2 % en poids, la teneur en oxyde de titane dans ladite poudre est dans la plage de 0,2 à 0,9 % en poids, et la teneur en oxyde de zirconium dans ladite poudre est dans la plage de 0,2 à 1 % en poids.

9. Métal de remplissage et de brasage selon la revendication 6, dans lequel ledit métal actif et au moins un métal choisi parmi le groupe comprenant titane, zirconium et hafnium ou un hydrure de ceux-ci.

10. Métal de remplissage et de brasage selon la revendication 6, dans lequel ledit matériau véhicule contient un liant acrylique et un solvant.
